# EUROPÄISCHE PATENTSCHRIFT

(11) **EP 2 288 646 B1**
(45) Veröffentlichungstag und Bekanntmachung des Hinweises auf die Patenterteilung: **10.07.2013**
(21) Anmeldenummer: 09776619.0
(22) Anmeldetag: 15.05.2009
(51) Int. Cl.: C08J 7/00, G02B 1/10, C23C 16/02, C23C 16/515, C23C 16/455, C23C 16/40

(54) **VERFAHREN ZUM ABSCHEIDEN EINER KRATZSCHUTZBESCHICHTUNG AUF EINEM KUNSTSTOFFSUBSTRAT**
METHOD FOR DEPOSITING A SCRATCH PROTECTION COATING ON A PLASTIC SUBSTRATE
PROCÉDÉ DE DÉPÔT D'UN REVÊTEMENT PROTECTEUR AUGMENTANT LA RÉSISTANCE MÉCANIQUE SUR UN SUBSTRAT DE MATIÈRE PLASTIQUE

(30) Priorität: 16.06.2008 DE 102008028537
(43) Veröffentlichungstag der Anmeldung: 02.03.2011
(73) Patentinhaber: Fraunhofer-Gesellschaft zur Förderung der angewandten Forschung e.V., 80686 München (DE)
(72) Erfinder: BARTZSCH, Hagen, 01309 Dresden (DE); FRACH, Peter, 01454 Radeberg (DE); TÄSCHNER, Kerstin, 01189 Dresden (DE); GLÖSS, Daniel, 01309 Dresden (DE); GOTTFRIED, Christian, 01219 Dresden (DE); FAHLAND, Matthias, 01257 Dresden (DE)
(86) Internationale Anmeldenummer: PCT/EP2009/003480
(87) Internationale Veröffentlichungsnummer: WO 2010/003477

(56) Entgegenhaltungen:
- EP-A- 0 718 418

## Beschreibung

Die Erfindung betrifft ein Verfahren zum Abscheiden einer Kratzschutzbeschichtung auf einem Kunststoffsubstrat, wobei der Abscheideprozess auf einer chemischen Reaktion beruht, die durch ein Plasma unterstützt wird.

Bei Anwendungen, bei denen Substrate eine optische Funktion ausüben, werden in zunehmendem Maße transparente Kunststoffe eingesetzt. So werden beispielsweise bei der Fertigung von Brillen mineralische Gläser immer öfter durch transparente Kunststofflinsen ersetzt. Ausschlaggebend hierfür sind vorteilhafte Eigenschaften transparenter Kunststoffsubstrate, wie geringeres spezifisches Gewicht, hohe Bruchsicherheit und leichte Formgebung. Nachteilig wirkt sich bei Kunststofflinsen jedoch die geringe Oberflächenhärte aus, wodurch sie empfindlicher gegenüber Kratzeinflüssen sind. Mit einer geeigneten transparenten Kratzschutzbeschichtung kann diesem Nachteil jedoch entgegengewirkt werden.

Aus dem Stand der Technik sind verschiedene Verfahren zum Abscheiden von transparenten Kratzschutzschichten auf Kunststoffsubstraten bekannt. Eine erste Gruppe bekannter Verfahren bilden nasschemische Verfahren, bei denen ein flüssiges oder gelartiges Ausgangsmaterial auf einem Substrat aufgetragen und anschließend ausgehärtet wird. In DE 199 40 312 A1 wird beispielsweise ein Polymer oder Oligomer auf die Oberfläche eines Gegenstandes aufgetragen und anschließend mittels UV-Strahlung ausgehärtet. Nasschemische Verfahren weisen jedoch eine Vielzahl von Nachteilen auf. Zum einen weisen die damit abgeschiedenen Schichten eine hohe Schwankungsbreite bezüglich der Schichtdickenverteilung auf. Zum anderen muss ein Substrat während der Zeit des Aushärtens oftmals unter kostenintensiven Reinraumbedingungen gelagert werden, damit sich keine Staub- und Schmutzpartikel in der Kratzschutzschicht festsetzen. Des Weiteren können beim Aushärten gesundheitsschädigende Lösungsmitteldämpfe freigesetzt werden.

Ebenfalls bekannt ist das Abscheiden von transparenten Kratzschutzschichten mittels sogenannter PVD-(physical vapor deposition)-Verfahren, bei denen ein Ausgangsmaterial beispielsweise durch Verdampfen oder Sputtern in die Dampfphase überführt und auf einem Substrat abgeschieden wird. Derart abgeschiedene Schichten weisen jedoch oftmals einen erheblich unterschiedlichen Wärmeausdehnungskoeffizienten gegenüber dem Substrat auf, wodurch solche Schichten im Laufe der Zeit zur Rissbildung neigen.

Eine weitere Gruppe sind sogenannte CVD-(chemical vapor deposition)-Verfahren, bei denen der Abscheideprozess auf einer chemischen Reaktion beruht. CVD-Verfahren und PVD-Verfahren werden üblicherweise unter verschiedenen Vakuumdruckbedingungen durchgeführt. Während CVD-Verfahren unter relativ hohen Druckverhältnissen (1 Pa bis 100 Pa) stattfinden, um den chemischen Abscheideprozess zu unterstützen, zählen PVD-Verfahren wie das Magnetronsputtern zu den Niederdruckverfahren (10⁻² Pa bis 1 Pa). CVD - und PVD-Verfahren in einer Vakuumkammer unter gleichen Druckverhältnissen durchzuführen ist daher nur technisch äußerst schwierig zu realisieren. Oftmals sind jedoch auf einem Kunststoffsubstrat neben einer Kratzschutzbeschichtung auch noch andere Schichtsysteme wie beispielsweise Entspiegelungsschichten abzuscheiden, welche üblicherweise mittels PVD-Verfahren abgeschieden werden. Wird eine Kratzschutzbeschichtung mittels CVD-Verfahren abgeschieden, sind dann für das Abscheiden weiterer Schichten meistens zusätzliche Vakuumarbeitskammern erforderlich.

Weiterhin bekannt ist das Abscheiden von Kratzschutzschichten mittels CVD, wobei die chemischen Reaktionen innerhalb einer Vakuumkammer aufgrund der Anwesenheit eines Plasmas angeregt werden. Derartige Verfahren werden als PCVD (plasma chemical vapor deposition) oder auch PECVD (plasma enhanced chemical vapor deposition) bezeichnet. Beim PCVD zum Abscheiden von Kratzschutzschichten auf einem Kunststoffsubstrat wird ein Plasma entweder mittels einer Mikrowellen-Quelle oder einer Hochfrequenz-(HF)-Quelle, die auch als Radio-Frequency-(RF)-Quelle bezeichnet sein kann, erzeugt. So wird beispielsweise in EP 0 718 418 A1 vorgeschlagen, Kratzschutzschichten auf Kunststoffsubstraten mittels eines so genannten Plasma-Impuls-CVD-Verfahrens abzuscheiden, bei welchem das Plasma mittels einer Einrichtung zum Erzeugen von Mikrowellen generiert wird.

EP 0 317 134 A2 beschreibt einen Gegenstand, bei dem auf einem Kunststoffsubstrat eine transparente abriebfeste Beschichtung aufgetragen wird, wobei eine ungesättigte Kohlenwasserstoffverbindung zusammen mit Silan und Sauerstoff in einer Vakuumkammer einem Mikrowellen- oder RF-Plasma ausgesetzt sind.

Derartig erzeugte Plasmen breiten sich jedoch großvolumig in einer Vakuumkammer aus, was den Nachteil mit sich bringt, dass eine Schichtabscheidung nicht nur auf der Oberfläche eines Substrates, sondern auch an ungeschützten inneren Bestandteilen einer Vakuumkammer erfolgt. Ein weiterer Nachteil von PCVD-Verfahren besteht darin, dass gute Kratzschutzeigenschaften erst ab Gesamtschichtdicken von etwa 4 µm erreicht werden. Beim Abscheiden einer solchen Schichtdicke entsteht eine relativ hohe thermische Substratbelastung, weshalb nach einer solchen Schichtabscheidung meist erst eine Substratkühlung durchgeführt werden muss, bevor eine weitere Schicht abgeschieden werden kann.

### Aufgabenstellung

Der Erfindung liegt daher das technische Problem zugrunde, ein Verfahren zum Abscheiden von Kratzschutzschichten durch eine plasmaunterstützte chemische Reaktion zu schaffen, mittels dem die Nachteile aus dem Stand der Technik überwunden werden können. Insbesondere soll es das erfindungsgemäße Verfahren ermöglichen Kratzschutzschichten abzuscheiden, die schon ab einer Gesamtschichtdicke von unter 4 µm gute Kratzschutzeigenschaften aufweisen. Des Weiteren sollen ungewollte Schichtablagerungen an Vakuumkammerbestandteilen sowie die thermische Belastung eines Substrates während der Schichtabscheidung vermindert werden.

Die Lösung des technischen Problems ergibt sich durch die Gegenstände mit den Merkmalen des Patentanspruchs 1. Weitere vorteilhafte Ausgestaltungen der Erfindung ergeben sich aus den abhängigen Patentansprüchen.

Bei einem erfindungsgemäßen Verfahren zum stationären Abscheiden einer transparenten Kratzschutzbeschichtung auf einem Kunststoffsubstrat mittels einer plasmaunterstützten chemischen Dampfabscheidung (PECVD), bei dem mindestens ein metallorganischer Precursor und mindestens ein Reaktivgas in eine Vakuumkammer geführt werden, wird das Plasma mittels eines gepulst betriebenen Magnetrons erzeugt. Dabei wird mindestens eine Schicht mit einer über die Schichtdicke stetigen oder sprunghaften Veränderung bezüglich der Schichtzusammensetzung abgeschieden. Da der Begriff Magnetron auch im Zusammenhang mit Einrichtungen zum Erzeugen von Mikrowellen verwendet wird, sei an dieser Stelle darauf verwiesen, dass der Begriff "Magnetron" im erfindungsgemäßen Sinne derartige Einrichtungen bezeichnet, die zum Sputtern verwendet werden.

Aus einem erfindungsgemäßen Verfahren resultiert entweder eine Kratzschutzschicht die sowohl organische als auch anorganische Bindungen aufweist und bei der ein kontinuierlicher Gradient bezüglich der Schichtzusammensetzung in Richtung des Schichtaufwuchses betrachtet ausgebildet ist, oder aber es entsteht eine Kratzschutzschicht bestehend aus mindestens zwei übereinander abgeschiedenen Teilschichten, deren Grenze eine sprunghafte Veränderung bezüglich der Schichtzusammensetzung aufweist und bei denen jede Teilschicht organische und anorganische Bindungen aufweist.

Das stetige oder sprunghafte Verändern bezüglich der Schichtzusammensetzung kann erfolgen, indem entweder die Flussmenge mindestens eines in die Vakuumkammer geführten Gases, die eingespeiste Magnetronleistung oder/und Pulsparameter der das Magnetron speisenden Stromversorgung stetig oder sprunghaft verändert werden.

Ein wesentliches Merkmal der Erfindung bildet das vor der zu beschichtenden Oberfläche eines Substrates angeordnete Magnetron, mit dem das Plasma für den PECVD-Prozess erzeugt wird. Überraschend konnte festgestellt werden, dass Kratzschutzschichten, die mittels Magnetron-PECVD abgeschieden wurden, bei denen das Plasma mittels eines Magnetrons erzeugt wurde, schon bei einer Gesamtschichtdicke von etwa 3 µm ausgezeichnete Kratzschutzeigenschaften aufweisen. Aber auch schon bei Schichtdicken ab 2 µm werden gute Kratzschutzeigenschaften erzielt. Bei einer geringeren erforderlichen Gesamtschichtdicke gegenüber dem Stand der Technik kann somit einerseits die Produktivität erhöht werden, andererseits sinkt gleichzeitig die thermische Belastung eines zu beschichtenden Substrates. Beim Abscheiden von weiteren Schichtsystemen, wie beispielsweise beim Herstellen von Brillengläsern, bei denen nach dem Abscheiden einer Kratzschutzbeschichtung auch noch weitere Schichtsysteme, wie zum Beispiel Schichtsysteme für eine Entspiegelung und/oder Schichtsysteme mit einer easy-to-clean-Funktion, abgeschieden werden, sind deshalb nur noch Kühlmaßnahmen in geringerem Umfang erforderlich. Bei einigen Anwendungsfällen kann dadurch auch gänzlich auf einen Kühlschritt nach dem Abscheiden der Kratzschutzbeschichtung verzichtet werden.

Als Magnetron zum Erzeugen des Plasmas für ein erfindungsgemäßes Verfahren sind jegliche Ausführungsformen von Magnetrons geeignet, die auch bei Sputterprozessen eingesetzt werden. Jedoch dient ein Magnetron beim erfindungsgemäßen Verfahren ausschließlich dem Zweck der Plasmaerzeugung. Ein Sputterbeitrag zur Schichtabscheidung ist bei einem erfindungsgemäßen Verfahren durch das Magnetron nicht beabsichtigt. Dennoch kann es zweckmäßig sein ein Magnetron mit einem Target zu bestücken, um das Magnetron selbst vor Sputtereinwirkungen zu schützen. So kann ein Magnetron beispielsweise mit einem Titantarget bestückt werden, weil Titan gegenüber anderen Sputtermaterialien eine geringere Sputterausbeute aufweist. Ein geringer Materialabtrag ist aber auch bei Verwendung eines Titantargets meist nicht vermeidbar. Jedoch haben diese geringen Mengen abgetragenen Materials keine negativen Auswirkungen auf die Eigenschaften und hier insbesondere auf die Transparenz der Kratzschutzbeschichtung, weil Titanoxid ebenfalls transparent ist.

Es kann beispielsweise auch eine mit zwei Targets bestückte Doppelmagnetronanordnung verwendet werden, bei der die beiden Targets mit einer bipolar pulsenden Stromversorgung gespeist werden.

Vorteilhaft ist weiterhin, dass das Plasma beim erfindungsgemäßen Verfahren aufgrund des Magnetron-Magnetfeldes hauptsächlich in durch Magnetfeldlinien begrenzten Bereichen zwischen Magnetron und der zu beschichtenden Substratoberfläche ausgebildet wird und dort mit einer hohen Plasmadichte. Ungewollte Schichtablagerungen an Vakuumkammerbestandteilen, wie bei Mikrowellen- oder HF-PECVD-Prozessen, werden dadurch reduziert.

Erfindungsgemäß werden mindestens ein metallorganischer Precursor (wobei auch ein sogenanntes Halbleitermetall, wie beispielsweise Silizium, als metallischer Bestandteil des Precursors fungieren kann) und ein anorganisches Reaktivgas in eine Vakuumkammer eingelassen. Dies kann durch einen Einlass oder aber auch durch getrennte Einlässe erfolgen. Ebenfalls kann auch noch ein Inertgas wie beispielsweise Argon in die Vakuumkammer eingelassen werden.

In der Vakuumkammer werden der metallorganische Precursor und das Reaktivgas einem Magnetronplasma ausgesetzt und Produkte einer durch das Plasma angeregten chemischen Reaktion auf einem Substrat abgeschieden.

Als Precursor kann zum Beispiel ein Silizium-haltiges Monomer, in dem auch noch Wasserstoff enthalten sein kann (beispielsweise HMDSO oder TEOS) verwendet werden, denn Schichten mit einem Siliziumoxidanteil sind besonders als Kratzschutzschichten geeignet.

Bei einer Ausführungsform werden daher ein Silizium-haltiges Monomer und Sauerstoff in eine Vakuumkammer eingelassen und einem Magnetronplasma ausgesetzt. Aufgrund der Plasmaeinwirkung wird zum einen das Monomer aufgespalten, zum anderen werden die aufgespaltenen Monomerbestandteile durch das Plasma gleichzeitig angeregt, neue chemische Verbindungen wie beispielsweise mit dem Reaktivgas einzugehen. Das Ergebnis der chemischen Reaktionen innerhalb der Vakuumkammer ist eine organisch vernetzte Siliziumoxid-Schicht, die auch noch Kohlenstoff- und Wasserstoffanteile aufweist. Dabei lässt sich beispielsweise über den Kohlenstoffanteil die Härte der abgeschiedenen Schicht verändern, wobei mit zunehmendem Kohlenstoffanteil in der abgeschiedenen Schicht die Härte der Schicht abnimmt.

Der Kohlenstoffanteil in der abgeschiedenen Schicht kann beispielsweise über die Zuflussmengen des Monomers und/oder des Reaktivgases Sauerstoff in die Vakuumkammer eingestellt werden. So bewirkt beispielsweise ein Erhöhen des in eine Vakuumkammer eingelassenen Sauerstoffanteils ein Verringern des Kohlenstoffanteils in der abgeschiedenen Schicht, weil aufgrund des zunehmenden Sauerstoffanteils in der Vakuumkammer vermehrt Siliziumoxid abgeschieden wird.

Bei einer Ausführungsform wird der Anteil des in eine Vakuumkammer eingelassenen Sauerstoffs während der Schichtabscheidung kontinuierlich erhöht. Dadurch entsteht eine Schicht, die mit zunehmendem Schichtwachstum einen abnehmenden Kohlenstoffanteil aufweist. Die auf diese Weise entstehende Gradientenschicht zeichnet sich daher durch eine vom Substrat ausgehende zunehmende Härte aus, die an der Schichtoberfläche am höchsten ist. Dadurch wird bezüglich der Härteeigenschaften ein kontinuierlicher Übergang vom relativ weichen Kunststoffsubstrat hin zu harten Schichtoberfläche vollzogen, wodurch zum einen gute Haftungseigenschaften und zum anderen gute Kratzschutzeigenschaften erzielt werden.

Besonders gute Kratzschutzeigenschaften werden erreicht, wenn die Kratzschutzbeschichtung als Schichtsystem, bestehend aus übereinander abgeschiedenen Teilschichten mit unterschiedlichen Härteeigenschaften, ausgebildet ist. Vorzugsweise wird hier zunächst eine Teilschicht mit geringerer Härte, dann eine Teilschicht mit höherer Härte, anschließend wieder eine Teilschicht mit geringerer Härte abgeschieden und so weiter. Für sehr gute Kratzschutzeigenschaften ist es hinreichend, wenn insgesamt jeweils drei bis sechs weiche und harte Teilschichten im Wechsel bei einer Gesamtdicke der Kratzschutzbeschichtung von 3 µm bis 5 µm abgeschieden werden. Das Einstellen der unterschiedlichen Härtegrade bei den einzelnen Teilschichten kann dabei mittels der gleichen Parameter erfolgen wie oben bezüglich der Gradientenschicht beschrieben. So können die einzelnen Teilschichten beispielsweise mit einem unterschiedlichen Kohlenstoffanteil ausgebildet werden. Er ist auch möglich, die einzelnen Teilschichten derart abzuscheiden, dass zumindest eine Teilschicht im Schichtdickenverlauf einen Gradienten bezüglich der Schichtzusammensetzung aufweist.

Die einzelnen Teilschichten mit unterschiedlichen Härteeigenschaften können mit gleicher Dicke der Teilschichten abgeschieden werden. Die weicheren Teilschichten können aber auch gegenüber den härteren Teilschichten mit einer bis zu 40 % geringeren Schichtdicke ausgebildet werden.

Bei einer weiteren Ausführungsform wird der Einlass, durch den ein Ausgangsstoff für die chemische Reaktion in die Vakuumkammer gelassen wird, zumindest im Bereich der Einlassöffnung als Elektrode einer Gasentladung geschaltet.

Durch eine solche Anordnung wird realisiert, dass sich in der Nähe der Einlassöffnung ein Plasma ausbildet. Da die Dichte des eingelassenen Ausgangsstoffes in unmittelbarer Umgebung der Einlassöffnung höher ist als im Mittel über dem gesamten Prozessraum, wird die Aktivierung des Ausgangsstoffes durch das Plasma auf diese Weise besonders effektiv realisiert und dadurch eine höhere Ausbeute bei der Schichtabscheidung erzielt. Wenn die Einlassrichtung des durch den Einlass eingeführten Ausgangsmaterials auch noch direkt auf die zu beschichtende Substratoberfläche gerichtet ist, so werden die durch das Plasma aktivierten Teilchen vorzugsweise am Substrat abgeschieden. Das gilt insbesondere dann, wenn bei der chemischen Dampfabscheidung der Prozessdruck unterhalb von 1 Pa liegt.

Bei einer Ausführungsform ist daher die Einlassrichtung des durch den Einlass geführten Ausgangsmaterials senkrecht zur zu beschichtenden Substratoberfläche oder mit einer Winkelabweichung zur Senkrechten in einem Bereich von ±10° ausgerichtet. Gute Ergebnisse werden diesbezüglich aber auch schon erzielt, wenn die Winkelabweichung zur Senkrechten nicht mehr als ±20° beträgt.

### Ausführungsbeispiel

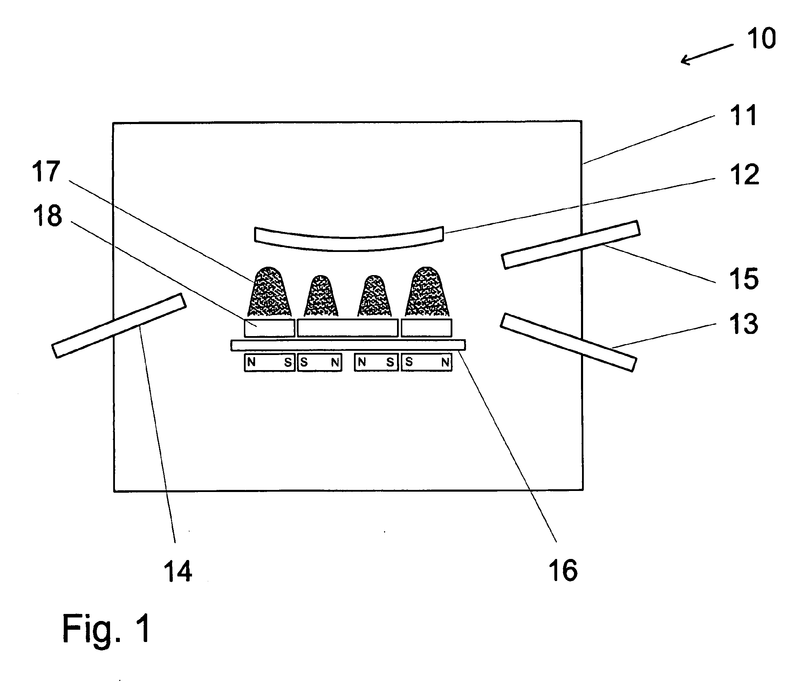

Die Erfindung wird nachfolgend anhand eines bevorzugten Ausführungsbeispiels näher erläutert. Die einzige Figur zeigt in einer schematischen Darstellung eine Vorrichtung 10 zum Abscheiden einer Kratzschutzbeschichtung.

In einer Vakuumkammer 11 befindet sich eine Brillenlinse 12 aus Polyallyldiglycol-Carbonat, auf der in einem stationären Beschichtungsprozess eine Kratzschutzschicht mittels eines Magnetron-PECVD-Verfahrens abgeschieden werden soll.

Dazu wird durch einen Einlass 13 das Monomer HMDSO, durch einen Einlass 14 Sauerstoff und durch einen Einlass 15 Argon in die Vakuumkammer 11 geführt. Mittels eines Doppelring-Magnetrons 16 wird zwischen dem Magnetron 16 und der zu beschichtenden Oberfläche der Brillenlinse 12 ein Plasma 17 ausgebildet, welches das Monomer aufspaltet und zur chemischen Reaktion mit anderen Gasbestandteilen innerhalb der Vakuumkammer 11 und der Oberfläche der Brillenlinse 12 anregt. Auf diese Weise wird auf der Brillenlinse 12 ein Material aus organisch vernetztem Siliziumoxid abgeschieden, welches neben einem Kohlenstoffanteil auch noch einen Wasserstoffanteil aufweist.

Das Magnetron 16 ist zwar mit Titantargets 18 (scheibenförmiges Innentarget und ringförmiges Außentarget) bestückt, jedoch wird das Magnetron 16 derart betrieben, dass möglichst kein Sputterabtrag an den Titantargets 18 erfolgt und somit möglichst keine Titanbestandteile am Schichtaufbau beteiligt sind.

In einem ersten Prozessschritt werden HMDSO mit 150 sccm und Sauerstoff mit 279 sccm in die Vakuumkammer 11 eingelassen. Dadurch wird eine erste Teilschicht mit relativ weichen Schichteigenschaften und mit einer Dicke von 0,4 µm abgeschieden. In einem zweiten Schritt wird der Einlass von HMDSO sprunghaft auf 45 sccm reduziert und der Einlass von Sauerstoff sprunghaft auf 400 sccm angehoben. Auf diese Weise reduziert sich der Kohlenstoffanteil in der mit einer Dicke von 0,5 µm abgeschiedenen zweiten Teilschicht, wodurch diese eine höhere Härte aufweist als die erste Teilschicht. Anschließend erfolgt wieder ein sprunghafter Wechsel auf die Einlassmengen wie beim Abscheiden der ersten Teilschicht. Insgesamt werden auf diese Weise jeweils vier weiche und vier harte Teilschichten im Wechsel mit 0,4 µm bzw. 0,6 µm Schichtdicke abgeschieden. Daraus resultiert eine Gesamtdicke für die aus insgesamt 8 Teilschichten bestehende Kratzschutzbeschichtung von 3,6 µm, die zunächst auf einer Seite der Brillenlinse aufgetragen ist. Nach dem Wenden der Brillenlinse wird auch auf der anderen Seite der Brillenlinse eine gleichartige Kratzschutzbeschichtung aufgetragen.

Die erfindungsgemäß abgeschiedene Beschichtung wurde anschließend einem Kratztest unterzogen. Bei einem hierfür üblicherweise verwendeten Stahlwolle-Abriebtest mit 10 Doppelhüben bei einer Last von 500 g konnten keine mit einem menschlichen Auge sichtbaren Beschädigungen festgestellt werden. Des Weiteren war nach der Kratzbelastung keine zusätzliche Eintrübung der Kratzschutzbeschichtung feststellbar bzw. hatte die Kratzeinwirkung keine Auswirkung auf die Transparenz der beschichteten Brillenlinse.

Bei Kratzschutzschichten, die nach dem Stand der Technik mit HF-Plasma unterstützten CVD Prozessen abgeschieden wurden, konnten derartige Kratzschutzeigenschaften erst bei Schichtdicken ab 6 µm erzielt werden.

## Patentansprüche

1. Verfahren zum Abscheiden einer transparenten Kratzschutzbeschichtung auf einem Kunststoffsubstrat mittels einer plasmaunterstützten chemischen Dampfabscheidung (PECVD), wobei mindestens ein metallorganischer Precursor und mindestens ein Reaktivgas in eine Vakuumkammer geführt werden, **dadurch gekennzeichnet, dass** das Plasma mittels eines gepulst betriebenen Sputter-Magnetrons erzeugt wird und mindestens eine Schicht mit einer über die Schichtdicke stetigen oder sprunghaften Veränderung bezüglich der Schichtzusammensetzung abgeschieden wird.

2. Verfahren nach Anspruch 1, **dadurch gekennzeichnet, dass** die Veränderung bezüglich der Schichtzusammensetzung durch ein stetiges oder sprunghaftes Verändern der Flussmenge mindestens eines in die Vakuumkammer geführten Gases erzeugt wird.

3. Verfahren nach Anspruch 1 oder 2, **dadurch gekennzeichnet, dass** die Veränderung bezüglich der Schichtzusammensetzung durch ein stetiges oder sprunghaftes Verändern der eingespeisten Sputter-Magnetronleistung erzeugt wird.

4. Verfahren nach einem der vorhergehenden Ansprüche, **dadurch gekennzeichnet, dass** die Veränderung bezüglich der Schichtzusammensetzung durch ein stetiges oder sprunghaftes Verändern von Pulsparametern der das Sputter-Magnetron speisenden Stromversorgung erzeugt wird.

5. Verfahren nach einem der vorhergehenden Ansprüche, **dadurch gekennzeichnet, dass** ein metallorganischer Precursor verwendet wird, der mindestens die Elemente Silizium und Wasserstoff aufweist.

6. Verfahren nach Anspruch 5, **dadurch gekennzeichnet, dass** innerhalb der Schicht mindestens zwei Teilschichten mit unterschiedlichem Kohlenstoffanteil übereinander abgeschieden werden.

7. Verfahren nach Anspruch 6, **dadurch gekennzeichnet, dass** die zwei Teilschichten mit einer unterschiedlichen Schichtdicke abgeschieden werden.

8. Verfahren nach einem der vorhergehenden Ansprüche, **dadurch gekennzeichnet, dass** ein Doppel-Sputter-Magnetron mit zwei Targets im bipolaren Pulsmodus betrieben wird.

9. Verfahren nach einem der vorhergehenden Ansprüche, **dadurch gekennzeichnet, dass** der Einlass mindestens eines in die Vakuumkammer geführten Ausgangsmaterials für die chemische Dampfabscheidung zumindest im Bereich der Einlassöffnung als Elektrode einer Gasentladung geschaltet wird.

10. Verfahren nach einem der vorhergehenden Ansprüche, **dadurch gekennzeichnet, dass** der Prozessdruck innerhalb der Vakuumkammer kleiner als 1 Pa eingestellt wird.

11. Verfahren nach einem der vorhergehenden Ansprüche, **dadurch gekennzeichnet, dass** die Kratzschutzbeschichtung mit einer Gesamtdicke von mindestens 2 µm und vorzugsweise von mindestens 3 µm abgeschieden wird.

## Claims

1. Method for depositing a transparent scratch protection coating on a plastic substrate by means of plasma-enhanced chemical vapour deposition (PECVD), wherein at least one metal-organic precursor and at least one reactive gas are fed into a vacuum chamber, **characterized in that** the plasma is generated by means of a pulsed sputtering magnetron and at least one layer is deposited with a continuous or abrupt change of the layer composition over the layer thickness.

2. Method according to Claim 1, **characterized in that** the change of the layer composition is produced by a continuous or abrupt change of the flow rate of at least one gas fed into the vacuum chamber.

3. Method according to Claim 1 or 2, **characterized in that** the change of the layer composition is produced by a continuous or abrupt change of the sputtering magnetron power that is fed in.

4. Method according to one of the preceding claims, **characterized in that** the change of the layer composition is produced by a continuous or abrupt change of pulse parameters of the current supply feeding the sputtering magnetron.

5. Method according to one of the preceding claims, **characterized in that** a metal-organic precursor which comprises at least the elements silicon and hydrogen is used.

6. Method according to Claim 5, **characterized in that** at least two part-layers of differing carbon content are deposited one on top of the other within the layer.

7. Method according to Claim 6, **characterized in that** the two part-layers are deposited with a differing layer thickness.

8. Method according to one of the preceding claims, **characterized in that** a dual sputtering magnetron with two targets is operated in a bipolar pulsed mode.

9. Method according to one of the preceding claims, **characterized in that** the inlet of at least one starting material for the chemical vapour deposition that is fed into the vacuum chamber is connected as an electrode of a gas discharge, at least in the region of the inlet opening.

10. Method according to one of the preceding claims, **characterized in that** the process pressure within the vacuum chamber is set lower than 1 Pa.

11. Method according to one of the preceding claims, **characterized in that** the scratch protection coating is deposited with a total thickness of at least 2 µm and preferably of at least 3 µm.

## Revendications

1. Procédé de dépôt d'un revêtement transparent de protection, contre les rayures sur un substrat en matière synthétique par recours à un dépôt chimique de vapeur soutenu par plasma (PECVD) dans lequel au moins un précurseur organométallique et au moins un gaz réactif sont amenés dans une chambre en dépression, **caractérisé en ce que**
le plasma est formé au moyen d'un magnétron de pulvérisation conduit de manière pulsée et
**en ce qu'**au moins une couche dont la composition varie de manière progressive ou brusque suivant l'épaisseur de la couche est déposée.

2. Procédé selon la revendication 1, **caractérisé en ce que** la modification de la composition de la couche est obtenue par une modification progressive ou brusque du débit d'écoulement d'au moins un gaz amené dans la chambre en dépression.

3. Procédé selon les revendications 1 ou 2, **caractérisé en ce que** la modification de la composition de la couche est obtenue par une modification progressive ou brusque de la puissance alimentant le magnétron de pulvérisation.

4. Procédé selon l'une des revendications précédentes, **caractérisé en ce que** la modification de la composition de la couche est obtenue par une modification progressive ou brusque des paramètres de pulsation de l'alimentation en courant qui alimente le magnétron de pulvérisation.

5. Procédé selon l'une des revendications précédentes, **caractérisé en ce qu'**il utilise un précurseur organométallique qui contient au moins les éléments silicium et hydrogène.

6. Procédé selon la revendication 5, **caractérisé en ce qu'**au moins deux couches partielles qui présentent différentes proportions de carbone sont déposées l'une au-dessus de l'autre dans la couche.

7. Procédé selon la revendication 6, **caractérisé en ce que** les deux couches partielles sont déposées sur des épaisseurs différentes.

8. Procédé selon l'une des revendications précédentes, **caractérisé en ce qu'**un magnétron de pulvérisation double présentant deux cibles est utilisé en mode pulsé bipolaire.

9. Procédé selon l'une des revendications précédentes, **caractérisé en ce qu'**au moins au niveau de l'ouverture d'admission, l'introduction d'au moins un matériau initial dans la chambre en dépression pour le dépôt chimique de vapeur est raccordée comme électrode de décharge dans un gaz.

10. Procédé selon l'une des revendications précédentes, **caractérisé en ce que** la pression de traitement à l'intérieur de la chambre en dépression est réglée à moins de 1 Pa.

11. Procédé selon l'une des revendications précédentes, **caractérisé en ce que** le revêtement de protection contre les rayures est déposé à une épaisseur totale d'au moins 2 µm et de préférence d'au moins 3 µm.
